# DEMANDE DE BREVET EUROPEEN

(11) **EP 4 765 179 A1**
(43) Date de publication de la demande: **24.06.2026**
(21) Numéro de dépôt: 25224994.1
(22) Date de dépôt: 18.12.2025
(51) Int. Cl.: H01H 1/00, G01R 31/327, G06V 10/774, G06V 20/52

(54) **PROCÉDÉ DE DIAGNOSTIC D'UN DISJONCTEUR ET PROGRAMME D ORDINATEUR ASSOCIÉ**

(30) Priorité: 19.12.2024 FR 2414657
(71) Demandeur: SCHNEIDER ELECTRIC INDUSTRIES SAS, 92500 Rueil-Malmaison (FR)
(72) Inventeur: LANES, David, 38660 SAINT HILAIRE DU TOUVET (FR); RAMEAU, Julien, 38430 SAINT JEAN DE MOIRANS (FR); RIVALS, Arnaud, 38320 HERBEYS (FR); PERROT, Florent, 38920 CROLLES (FR); LAYDEVANT, Nicolas, 38100 GRENOBLE (FR); HAGE, Benoit, 38430 SAINT JEAN DE MOIRANS (FR); CATHIGNOL, Augustin, 38000 GRENOBLE (FR); D'EUSTACHIO, Fabrice, 38410 VAULNAVEYS-LE-BAS (FR); STOLYAROVA, Elena, 38120 FONTANIL-CORNILLON (FR)
(74) Mandataire: Lavoix

(57) **Abrégé**

La présente invention concerne un procédé de diagnostic (200) d'un disjoncteur comprenant au moins un pôle, chaque pôle comprenant un contact électrique configuré pour basculer entre une position fermée et une position ouverte.

Le procédé comprend :
- pour chaque pôle du disjoncteur, au moins une prise de vue (208A, 208B) du contact électrique du pôle ;
- pour chaque pôle du disjoncteur, au moins une détermination (218A, 218B) d'un état de santé du pôle parmi au moins deux états au moyen d'un algorithme d'intelligence artificielle, l'algorithme d'intelligence artificielle prenant en entrée l'au moins une prise de vue du pôle et fournissant en sortie l'état de santé du pôle ;
- une détermination (220A, 220B) d'un état de santé du disjoncteur parmi au moins deux états, en fonction de l'état de santé de chaque pôle ; et
- une restitution (222, 224) de l'état de santé du disjoncteur.

## Description

La présente invention concerne un procédé de diagnostic d'un disjoncteur. Elle concerne également un programme d'ordinateur associé.

Les disjoncteurs sont des dispositifs de sécurité essentiels permettant d'interrompre un courant dans une installation électrique en cas de défaut électrique. Il est donc important de suivre l'état de santé des disjoncteurs présents dans une installation électrique, afin de s'assurer de leur capacité à sécuriser l'installation électrique et de les remplacer si nécessaire.

La durée de vie d'un disjoncteur est, en particulier, déterminée par un nombre de cycles d'ouverture/fermeture et d'une valeur de courant coupé. En connaissant le nombre de cycles passés et le courant coupé, il est donc possible d'estimer la durée de vie restante du disjoncteur.

Or, en situation réelle, l'information sur le nombre de cycles passés et le courant coupé n'est disponible que pour une quantité de disjoncteur très restreinte, équipés d'une unité de déclenchement électronique avancée comprenant un accessoire de comptage des occurrences d'ouverture/fermeture du disjoncteur et de mesure de courant coupé. Dans tous les autres cas, aucune méthode ne permet actuellement à un opérateur de déterminer efficacement l'état de santé d'un disjoncteur au sein d'une installation électrique, ni donc d'en déduire si un remplacement est nécessaire pour continuer à assurer les fonctions de sécurité.

Le but de l'invention est alors de proposer un procédé de diagnostic d'un disjoncteur permettant de déterminer *in situ* l'état de santé d'un disjoncteur, non nécessairement équipé d'une unité de déclenchement électronique avancée, sans nécessiter de retrait préalable du disjoncteur de l'installation électrique.

A cet effet, l'invention a pour objet un procédé de diagnostic d'un disjoncteur comprenant au moins un pôle, chaque pôle comprenant un contact électrique configuré pour basculer entre une position fermée et une position ouverte, caractérisé en ce que le procédé comprend :
- pour chaque pôle du disjoncteur, au moins une prise de vue du contact électrique du pôle ;
- pour chaque pôle du disjoncteur, au moins une détermination d'un état de santé du pôle parmi au moins deux états au moyen d'un algorithme d'intelligence artificielle, l'algorithme d'intelligence artificielle prenant en entrée l'au moins une prise de vue du pôle et fournissant en sortie l'état de santé du pôle ;

- une détermination d'un état de santé du disjoncteur parmi au moins deux états, en fonction de l'état de santé de chaque pôle ; et
- une restitution de l'état de santé du disjoncteur.

Grâce à l'invention, l'état de santé du disjoncteur est estimé *in situ* à partir d'une prise de vue réalisée directement sur l'installation électrique. En particulier, le procédé, par l'usage de l'intelligence artificielle, permet de réaliser une analyse des contacts du disjoncteur qui serait difficile voire impossible à réaliser par une personne non experte sans connaissance fine de la structure du disjoncteur ni connaissance de conditions de vieillissement des pastilles de contact. Grâce au procédé de l'invention, il est possible de conclure quant à la nécessité de remplacer ou non le disjoncteur pour continuer à assurer la sécurité de l'installation électrique. En outre, la réalisation d'une prise de vue permet d'éviter d'avoir à démonter le disjoncteur, ce qui représente un gain de praticité et de temps important.

Suivant d'autres aspects avantageux de l'invention, le procédé de diagnostic comprend une ou plusieurs des caractéristiques suivantes, prises isolément ou suivant toutes les combinaisons techniquement possibles :
- pour chaque pôle du disjoncteur :
   - la prise de vue du contact électrique est réalisée au moyen d'une sonde endoscopique ; et
   - le procédé comprend, préalablement à la prise de vue, une insertion de la sonde endoscopique dans le disjoncteur à proximité d'une pastille de contact mobile appartenant au contact électrique ;
- pour chaque pôle du disjoncteur :
   - la ou l'une des prise(s) de vue est réalisée alors que le contact électrique du pôle est en position ouverte ; et
   - l'algorithme d'intelligence artificielle utilisé dans la ou l'une des détermination(s) de l'état de santé du pôle est un algorithme de classification prenant en entrée la ou l'une des prise(s) de vue réalisée(s) alors que le contact électrique est en position ouverte et fournissant en sortie un état du pôle parmi un état critique, un état non conforme, un état conforme et un état bon ;
- pour chaque pôle du disjoncteur :
   - la ou l'une des prise(s) de vue est réalisée alors que le contact électrique du pôle est en position fermée ; et
   - l'algorithme d'intelligence artificielle utilisé dans la ou l'une des détermination(s) de l'état de santé du pôle est un algorithme de détection d'anomalie prenant en entrée la ou l'une des prise(s) de vue réalisée(s) alors que le contact électrique est en position fermée et fournissant en sortie un état du pôle parmi un état de répulsion et un état de non-répulsion ;
- la détermination de l'état de santé du disjoncteur est effectuée entre un état valide et un état non valide, l'état non valide étant déterminé si, pour au moins un pôle :
   - l'état de santé du pôle prédit par l'algorithme de classification est l'état critique ou l'état non conforme, ou
   - l'état de santé du pôle prédit par l'algorithme de détection d'anomalie est l'état de répulsion ;
l'état valide étant déterminé sinon ;
- la ou les prise(s) de vue des contacts électriques en position fermée et la ou les détermination(s) au moyen de l'algorithme de détection d'anomalie sont réalisées si et seulement si l'état de santé de chaque pôle prédit par l'algorithme de classification est l'état bon ou l'état conforme ;
- le procédé comprend en outre, pour chaque prise de vue, au moins une action d'adaptation de la prise de vue parmi une conversion de la prise de vue en niveaux de gris, une normalisation d'un contraste de la prise de vue et un redimensionnement de la prise de vue ;
- chaque algorithme d'intelligence artificielle a été entraîné au cours d'une phase d'initialisation préalable au procédé, chaque phase d'initialisation comprenant :
   - pour chaque disjoncteur d'entraînement parmi un ensemble de disjoncteurs d'entraînement et pour chaque pôle du disjoncteur d'entraînement, au moins une prise de vue du contact du pôle ;
   - pour au moins une prise de vue obtenue, au moins une action de transformation aléatoire de la prise de vue ; et
   - un entraînement de l'algorithme d'intelligence artificielle sur au moins un ensemble de prises de vue d'entraînement parmi les prises de vue ;
- la phase d'initialisation de l'algorithme de classification comprend en outre :
   - pour chaque prise de vue, une attribution par un expert d'un premier état de santé réel du pôle parmi un état critique réel, un état non conforme réel, un état conforme réel et un état bon réel ; et
   - une répartition des prises de vues obtenues en un premier ensemble d'entraînement, un premier ensemble de validation et un premier ensemble de test, chaque premier ensemble comprenant au moins une prise de vue appartenant à chaque état parmi l'état critique réel, l'état non conforme réel, l'état conforme réel et l'état bon réel, l'entraînement comprenant un entraînement, une validation et un test de l'algorithme de classification sur le premier ensemble d'entraînement, le premier ensemble de validation et le premier ensemble de test respectivement ;
- la phase d'initialisation de l'algorithme de détection d'anomalie comprend en outre :
   - pour chaque prise de vue, une attribution par un expert d'un deuxième état de santé réel du pôle parmi un état de répulsion réel et un état de non répulsion réel ; et
   - une répartition des prises de vues obtenues en un deuxième ensemble d'entraînement, un deuxième ensemble de validation et un deuxième ensemble de test, le deuxième ensemble d'entraînement comprenant uniquement des prises de vue dont le deuxième état de santé réel est l'état de répulsion réel et les deuxièmes ensembles de validation et de test comprenant au moins une prise de vue appartenant à chaque état parmi l'état de répulsion réel et l'état de non répulsion réel, l'entraînement comprenant un entraînement, une validation et un test de l'algorithme de détection d'anomalie sur le deuxième ensemble d'entraînement, le deuxième ensemble de validation et le deuxième ensemble de test respectivement ;

   - l'action de transformation aléatoire comprend au moins une action parmi une modification aléatoire d'un contraste de la prise de vue, une modification aléatoire d'une luminosité de la prise de vue, une rotation aléatoire de la prise de vue et un décalage horizontal ou vertical aléatoire de la prise de vue.

L'invention concerne également un programme d'ordinateur comportant des instructions logicielles qui, lorsqu'elles sont exécutées par un ordinateur, mettent en œuvre un procédé de diagnostic tel que défini ci-dessus.

L'invention apparaîtra plus clairement à la lecture de la description qui va suivre, donnée uniquement à titre d'exemple non limitatif, et faite en référence aux dessins dans lesquels :
[Fig. 1] la figure 1 est une vue en perspective d'un dispositif permettant de mettre en œuvre un procédé selon l'invention ;
[Fig. 2] la figure 2 est un schéma en coupe d'une partie d'un disjoncteur et d'une partie du dispositif de la figure 1 ;
[Fig. 3] la figure 3 est une coupe longitudinale du dispositif de la figure 1 ;
[Fig. 4] la figure 4 est une vue en perspective d'un guide appartenant au dispositif de la figure 1 selon deux angles de vue distincts ;
[Fig. 5] la figure 5 est une vue en perspective d'une entretoise, une première bague d'entretoise et une quatrième bague d'entretoise appartenant au dispositif de la figure 1 ;
[Fig. 6] la figure 6 est une vue en perspective et une vue en coupe d'une deuxième bague d'entretoise et une vue en perspective d'une troisième bague d'entretoise appartenant au dispositif de la figure 1 ;
[Fig. 7] la figure 7 est une vue de côté du dispositif de la figure 1 en position désengagée ;
[Fig. 8] la figure 8 est un logigramme d'une phase d'initialisation selon l'invention ;
[Fig. 9] la figure 9 est un logigramme d'un procédé de diagnostic selon l'invention.

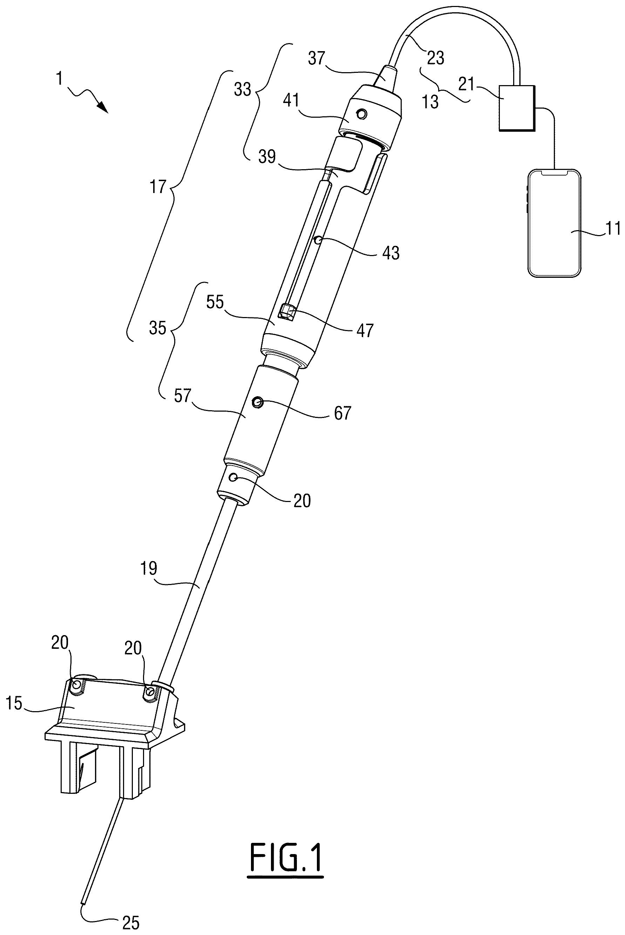

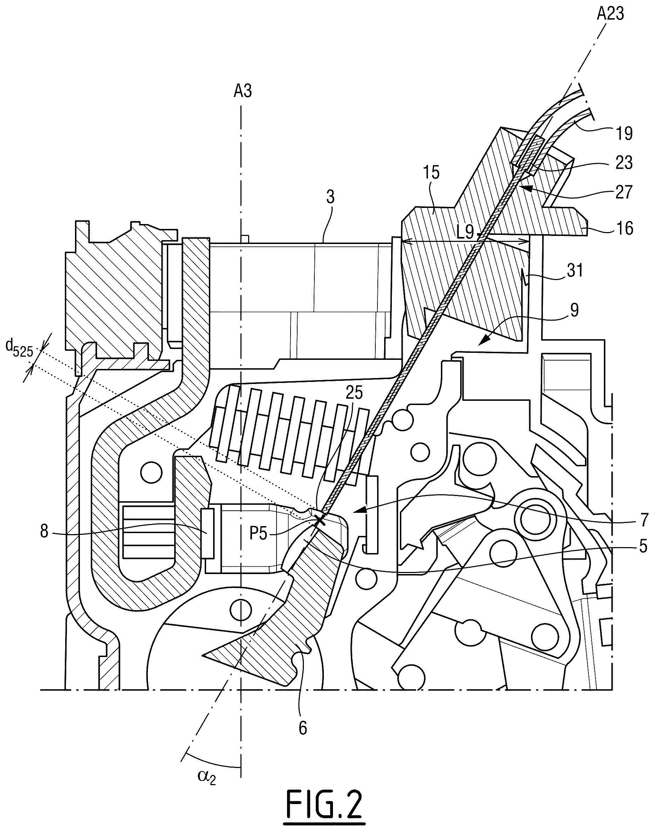

La figure 1 représente un dispositif 1 de prise de vue d'un contact d'un disjoncteur 3, représenté partiellement sur la figure 2.

Le disjoncteur 3 est par exemple un disjoncteur à boîtier moulé, dit MCCB (de l'anglais *Moulded Case Circuit Breaker*). Sa fonction est de détecter un défaut électrique survenant dans une installation électrique non représentée et d'interrompre un courant circulant dans l'installation électrique en cas de défaut. Le disjoncteur 3 comprend au moins un pôle, généralement trois pôles correspondant à trois phases pour une installation électrique triphasée, ou bien quatre pôles correspondant à trois phases et un neutre pour une installation électrique tétrapolaire. La structure d'un pôle du disjoncteur 3 est partiellement visible sur la vue en coupe de la figure 2. En particulier, chaque pôle comprend un contact électrique configuré pour basculer entre une position fermée et une position ouverte. Chaque contact électrique comprend une partie fixe portant une pastille de contact fixe 8 et une partie mobile 6 portant une pastille de contact mobile 5. Les pastilles de contact fixe 8 et mobile 5 permettent d'établir ou d'interrompre un passage du courant entre la partie fixe et la partie mobile, en fonction d'une position ouverte ou fermée de la partie mobile 6. Le plan de coupe de la figure 2 permet de visualiser un pôle, avec sa pastille de contact mobile 5, les autres pôles étant similaires.

En fonctionnement normal du disjoncteur 3, lorsque le contact électrique d'un pôle est en position fermée, le disjoncteur 3 laisse passer le courant électrique dans la phase ou le neutre correspondant au pôle. A l'inverse, lorsque le contact électrique est en position ouverte, le disjoncteur 3 s'oppose au passage du courant dans la phase ou le neutre correspondant au pôle.

Chaque pôle est avantageusement confiné dans une ampoule, séparée des autres pôles. Pour chaque pôle, l'ampoule définit un volume 7 communicant avec l'extérieur du disjoncteur 3 via une chambre d'échappement 9.

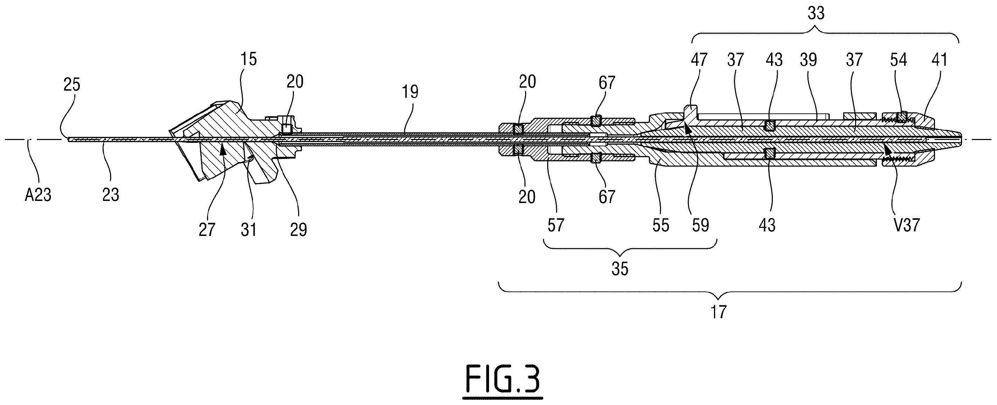

Le dispositif de prise de vue 1, représenté en perspective sur la figure 1 et en coupe sur les figures 2 et 3, est configuré pour réaliser des prises de vue des contacts électriques du disjoncteur 3. Le dispositif 1 est en outre relié à un dispositif externe 11, configuré pour mettre en œuvre un procédé de diagnostic du disjoncteur 3 détaillé dans la suite.

Le dispositif de prise de vue 1 comprend une sonde endoscopique 13, un guide 15 et un organe de butée 17. Avantageusement, le dispositif de prise de vue 1 comprend en outre un tuyau 19.

La sonde endoscopique 13 comprend un corps de sonde 21 et une fibre optique 23. La sonde endoscopique 13 est configurée pour réaliser des prises de vue d'éléments environnants d'une extrémité distale 25 de la fibre optique 23.

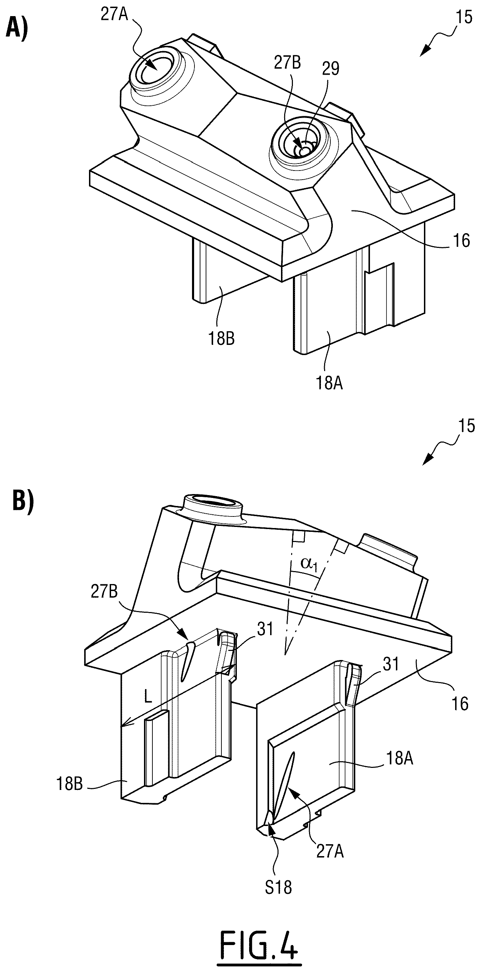

Le guide 15 est configuré pour pénétrer au moins partiellement dans la chambre d'échappement 9 du pôle comprenant le contact électrique dont on cherche à réaliser la prise de vue, comme visible sur la figure 2. Pour ce faire, le guide 15 est une pièce de géométrie complémentaire d'une forme de la chambre d'échappement 9. Le guide 15 est représenté plus en détail sur la figure 4, selon deux angles de vue distincts correspondant respectivement aux inserts A et B.

Le guide 15 comprend au moins une cavité rectiligne 27, configurée pour recevoir la fibre optique 23 et pour guider la fibre optique 23 jusqu'à un point P5 à proximité de la pastille de contact 5. En particulier, le guide 15 est configuré pour guider la fibre optique 23 à travers la chambre d'échappement 9, la fibre optique 23 étant ensuite guidée par des pièces mécaniques appartenant au disjoncteur 3 pour arriver dans le volume 7, à proximité de la pastille de contact 5. Ainsi, le guide 15 permet d'accéder à une vue des contacts du disjoncteur 3 *in situ* sur l'installation électrique, sans démontage préalable du disjoncteur 3. La vue d'un contact du disjoncteur 3 comprend avantageusement la pastille de contact mobile 5, des joues positionnées de part et d'autre de la pastille de contact mobile 5 ainsi qu'un pare-étincelle.

La forme rectiligne de la cavité 27 permet de ne pas tordre la fibre optique 23, limitant les risques d'endommagement de la fibre optique 23. En outre, le diamètre de la cavité 27 offre avantageusement un jeu de l'ordre de 0.1mm par rapport au diamètre externe de la fibre optique 23, ce qui permet une insertion aisée de la fibre optique 23, tout en offrant un bon maintien de la fibre optique 23 et une dispersion optique relativement faible.

Comme visible sur les figures 3 et 4, la cavité rectiligne 27 comprend un chanfrein d'embouchure 29, facilitant l'insertion de la fibre optique 23 dans la cavité 27. Le chanfrein 29 est positionné sur une face du guide 15 opposée à l'extrémité distale 25 de la fibre optique 23 lorsque la fibre optique 23 est insérée dans la cavité 27.

Dans l'exemple des figures, le guide 15 comprend deux cavités 27A et 27B formant entre elles un angle α₁ non nul, de manière à guider la fibre optique 23 jusqu'au même point P5 à proximité de la pastille de contact mobile 5, quelle que soit la cavité dans laquelle est introduite la fibre optique 23. En d'autres termes, des prolongements axiaux des deux cavités 27A et 27B convergent vers le point P5. Ainsi, la fibre optique en place dans l'une ou l'autre des cavités 27A et 27B permet de visualiser le même contact, sous deux angles de vue.

Avantageusement, le guide 15 comprend au moins une languette flexible 31 permettant d'adapter une largeur L du guide 15 à une largeur L9 de la chambre d'échappement 9, comme bien visible sur la figure 2. Cette caractéristique permet une bonne tenue du guide 15 et une prise en compte de tolérances sur la largeur L9 des chambres d'échappement 9 d'un pôle à un autre et d'un disjoncteur 3 à un autre.

Avantageusement, le guide 15 comprend une embase 16 et deux pattes 18A et 18B qui s'étendent parallèlement l'une à l'autre à partir de l'embase 16. Le guide 15 est monobloc.

Avantageusement, les cavités 27A et 27B traversent l'embase 16. Chaque cavité 27A ou 27B se prolonge à l'extérieur de la patte qu'elle traverse, comme visible sur la patte 18B de l'insert B) de la figure 4, puis à l'intérieur de la patte qu'elle traverse, comme visible sur la patte 18A de l'insert B) de la figure 4. Chacune des cavités 27A et 27B débouche avantageusement sur l'intérieur de la patte 18A ou 18B qu'elle traverse.

Le plan de coupe de la figure 2 passe par la patte 18B et la cavité 27 visible sur cette figure correspond à la cavité 27B représentée à la figure 4.

De préférence, chaque patte 18A ou 18B est configurée pour ne pas gêner le passage de la fibre optique 23, ni la blesser lors de sa progression vers le point P5. Ainsi, le côté de la patte 18A visible sur l'insert B) de la figure 4 comporte une découpe qui définit une surface S18 de guidage de la fibre optique 23 à sa sortie de la cavité 27A.

L'organe de butée 17 est configuré pour maintenir longitudinalement la fibre optique 23 insérée dans le guide 15 en fixant une distance d525 entre l'extrémité distale 25 de la fibre optique 23 et la pastille de contact mobile 5, ainsi qu'un angle α₂ entre un axe longitudinal A3 du disjoncteur 3 et un axe longitudinal A23 de la fibre optique 23. Cette caractéristique permet une plus grande reproductibilité de la prise de vue au moyen du dispositif 1.

L'organe de butée 17 se décompose avantageusement en un élément de butée proximal 33 et un élément de butée distal 35. L'élément de butée proximal 33 est solidaire de la sonde endoscopique 13 tandis ce que l'élément de butée distal 35 est solidaire du guide 15, à travers le tuyau 19, comme expliqué ci-après.

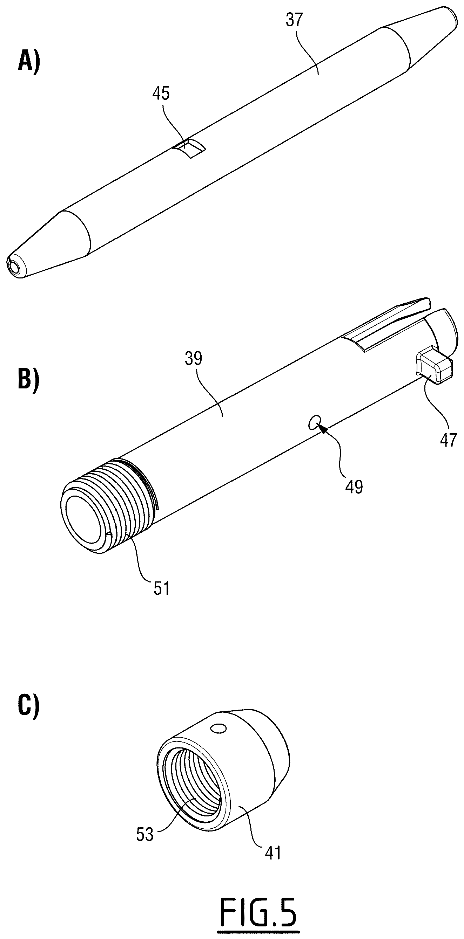

Dans l'exemple illustré, l'élément de butée proximal 33 comprend une entretoise 37, une première bague d'entretoise 39 et un bouchon 41. Ces différents composants sont montrés individuellement sur les inserts A), B) et C) de la figure 5.

L'entretoise 37 est configurée pour encercler partiellement la fibre optique 23 en étant solidaire de la fibre optique 23. Pour ce faire, au moins une vis de serrage 43, avantageusement deux vis de serrage 43 comme visible à la figure 3, serrent l'entretoise 37 de manière à réduire localement un diamètre d'un volume interne V37 de l'entretoise 37 servant à recevoir la fibre optique 23 et ainsi à solidariser l'entretoise 37 avec la fibre optique 23. Dans l'exemple illustré, les deux vis de serrage 43 servent également à solidariser l'entretoise 37 avec la première bague d'entretoise 39. L'entretoise 37 comprend avantageusement au moins une encoche 45 pour recevoir partiellement la ou chaque vis de serrage 43.

La première bague d'entretoise 39 encercle au moins partiellement l'entretoise 37 en étant solidaire de l'entretoise 37. Comme représenté sur l'insert B) la figure 5, la première bague d'entretoise 39 comprend une butée mâle 47, ainsi que deux trous 49 permettant le passage des vis de serrage 43. Avantageusement, la première bague d'entretoise 39 comprend en outre un premier filetage externe 51 permettant de coopérer avec le bouchon 41.

Le bouchon 41, représenté sur l'insert C) de la figure 5, comprend avantageusement un deuxième filetage interne ou taraudage 53 configuré pour coopérer avec le premier filetage externe 51. Le bouchon 41 est avantageusement solidarisé à la première bague d'entretoise 29 au moyen d'une vis de liaison 54. Le bouchon 41 permet de faciliter la préhension de l'organe de butée 17 par un opérateur et de maintenir l'entretoise 37 dans la première bague d'entretoise 39.

Comme représenté sur les figures 1 et 3, l'élément de butée distal 35 est relié au guide par l'intermédiaire du tuyau 19, configuré pour recevoir la fibre optique 23. En particulier, le tuyau 19 est fixé au guide 15 et à l'élément de butée distal 35 au moyen de vis de montage 20. Les vis de montage 20 sont reçues par des trous respectifs sur le guide 15 et sur l'élément de butée distal 35.

Ainsi, la fibre optique 23 traverse l'élément de butée proximal 33, l'élément de butée distal 35, le tuyau 19 puis le guide 15.

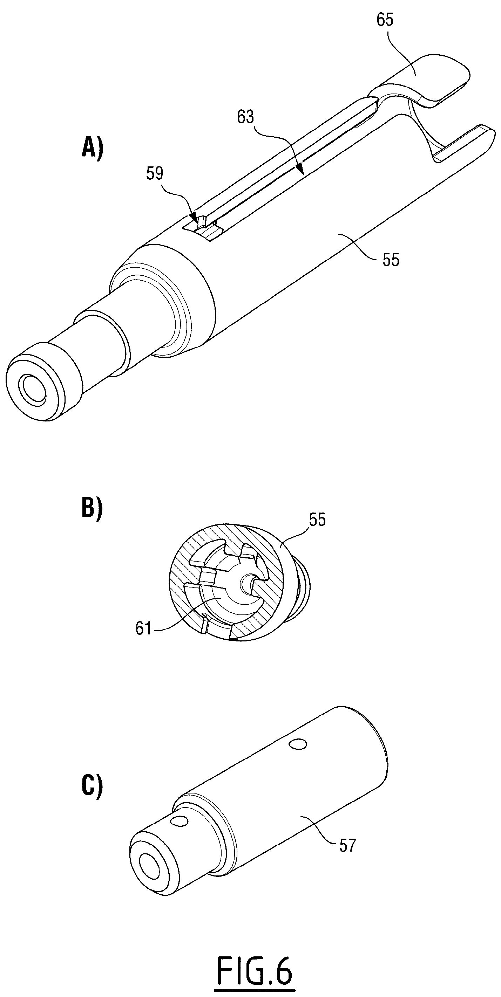

L'élément de butée distal 35 comprend une deuxième bague d'entretoise 55 ainsi qu'en complément facultatif une troisième bague d'entretoise 57. Ces éléments sont représentés individuellement sur la figure 6.

En configuration montée de l'organe de butée 17, la deuxième bague d'entretoise 55 encercle au moins partiellement la première bague d'entretoise 39. La deuxième bague d'entretoise 55 est mobile en translation par rapport à la première bague d'entretoise 39 le long de l'axe longitudinal A23 de la fibre optique 23 et en rotation par rapport à la première bague d'entretoise 39 autour de l'axe longitudinal A23 de la fibre optique 23. La deuxième bague d'entretoise 55 comprend une butée femelle 59, configurée pour coopérer avec la butée mâle 47. L'insertion de la butée mâle 47 dans la butée femelle 59 permet de solidariser la deuxième bague d'entretoise 55, donc l'élément de butée distal 35, avec la première bague d'entretoise 39, donc l'élément de butée proximal 33, à la façon d'une baïonnette. En d'autres termes, l'insertion de la butée mâle 47 dans la butée femelle 59 permet de bloquer la translation et la rotation entre la fibre optique 23 et le guide 15 par rapport à l'axe longitudinal A23 de la fibre optique 23. Puisque le guide 15 est maintenu par le disjoncteur 3 lorsque le guide 15 est inséré dans la chambre d'échappement 9, l'insertion de la butée mâle 47 dans la butée femelle 59 permet de fixer la position de la fibre optique 23 par rapport au disjoncteur 3, et notamment par rapport à la pastille de contact mobile 5. On comprend donc que l'organe de butée 17 permet d'améliorer la répétabilité de la prise de vue des contacts électriques, au moyen de la sonde endoscopique 13.

Avantageusement, la deuxième bague d'entretoise 55 comprend, en outre, un chanfrein d'embouchure 61 facilitant l'insertion de la fibre optique 23 dans la deuxième bague d'entretoise 55, comme visible sur la vue en coupe de l'insert B) de la figure 6.

Dans l'exemple illustré, la deuxième bague d'entretoise 55 comprend, en outre, une rainure de dégagement 63, parallèle à l'axe longitudinal A23 de la fibre optique 23. La rainure de dégagement 63 est configurée pour coopérer avec la butée mâle 47 et pour guider, via la butée mâle 47, la première bague d'entretoise 39 en translation par rapport à la deuxième bague d'entretoise 55, à partir de la butée femelle 59, le long de l'axe longitudinal A23 de la fibre optique 23, jusqu'à ce que la fibre optique 23 soit intégralement en dehors du disjoncteur 3.

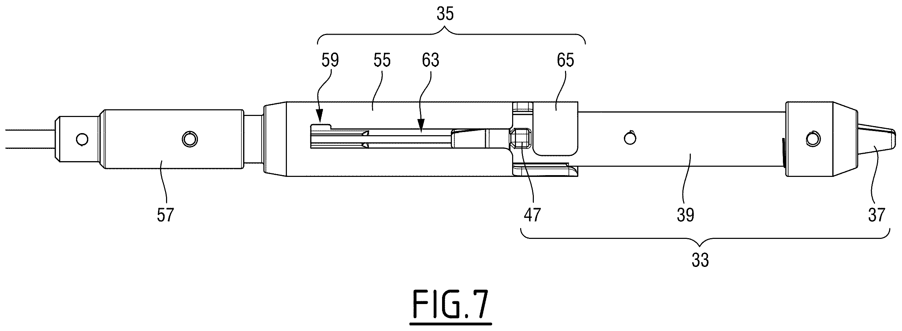

Avantageusement, la deuxième bague d'entretoise 55 comprend en outre une butée de dégagement 65 bloquant la translation de la première bague d'entretoise 39 par rapport à la deuxième bague d'entretoise 55 lorsque la fibre optique 23 est intégralement en dehors du disjoncteur 3. On dit alors que le dispositif 1 est en position dégagée. La position dégagée est représentée sur la figure 7. La position dégagée permet à un opérateur de retirer le guide 15 du disjoncteur 3 sans endommager la fibre optique 23, qui est généralement fragile et représente la majeure partie du coût du dispositif 1.

Dans l'exemple illustré, une rotation de l'élément de butée proximal 33 par rapport à l'élément de butée distal 35, alors que le dispositif 1 est en position dégagée, permet de retirer l'élément de butée proximal 33 de l'élément de butée distal 35. Ainsi, le guide 15 et la sonde endoscopique 13 sont de nouveau indépendants.

La troisième bague d'entretoise 57 encercle au moins partiellement la deuxième bague d'entretoise 55. La troisième bague d'entretoise 57 est mobile en translation le long de l'axe longitudinal A23 de la fibre optique 23, par rapport à la deuxième bague d'entretoise 55, et en rotation autour de l'axe longitudinal A23 de la fibre optique 23, par rapport à la deuxième bague d'entretoise 55. La troisième bague d'entretoise 57 est solidarisée avec la deuxième bague d'entretoise 55 au moyen de vis de microréglage 67. Ainsi, la rotation et la translation entre la deuxième bague d'entretoise 55 et la troisième bague d'entretoise 57 lorsque les vis de microréglage sont desserrées permet de régler finement la position de la fibre optique 23 par rapport au disjoncteur 3, après insertion de la butée mâle 47 dans la butée femelle 59.

Les différents composants précités du dispositif de prise de vue 1, hormis la sonde endoscopique 13 et le tuyau 19, sont avantageusement imprimés en 3D à partir de résine. Plus généralement, le dispositif 1 est au moins en partie imprimé en 3D à partir de résine. Ce mode de fabrication impose que toutes les dimensions de ces composants soient supérieures ou égales à 0.3 mm.

Le dispositif externe 11 est relié au corps de sonde 21 par une liaison filaire ou sans-fil, de manière à recevoir les prises de vues réalisées par la sonde endoscopique 13.

Le dispositif externe 11 est avantageusement un smartphone ou une tablette sur lequel ou laquelle est installée une application configurée pour mettre en œuvre le procédé de diagnostic du disjoncteur 3.

Plus généralement, le dispositif externe 11 comprend un circuit électronique conçu pour manipuler et/ou transformer des données représentées par des quantités électroniques ou physiques dans des registres et/ou des mémoires en d'autres données similaires correspondant à des données physiques dans les mémoires de registres ou d'autres types de dispositifs d'affichage, de dispositifs de transmission ou de dispositifs de mémorisation.

En tant qu'exemples spécifiques, le dispositif externe 11 est réalisé sous forme d'un composant logique programmable, tel qu'un FPGA (de l'anglais *Field Programmable Gate Array*), ou encore d'un circuit intégré, tel qu'un ASIC (de l'anglais *Application Specific Integrated Circuit*).

En variante, lorsque le procédé de diagnostic est réalisé sous forme d'un ou plusieurs logiciels, c'est-à-dire sous forme d'un programme d'ordinateur, également appelé produit programme d'ordinateur, il est en outre apte à être enregistré sur un support, non représenté, lisible par ordinateur. Le support lisible par ordinateur est par exemple un medium apte à mémoriser des instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple FLASH ou NVRAM) ou une carte magnétique. Sur le support lisible est alors mémorisé un programme d'ordinateur comprenant des instructions logicielles.

Le procédé de diagnostic consiste à déterminer un état de santé du disjoncteur 3 à partir de prises de vue des contacts électriques du disjoncteur 3 réalisées par le dispositif 1 décrit ci-dessus et au moyen d'au moins un algorithme d'intelligence artificielle. Chaque algorithme d'intelligence artificielle prend en entrée une prise de vue d'un contact électrique d'un pôle et fournit en sortie un état de santé du pôle. Plus précisément, chaque algorithme d'intelligence artificielle fournit une probabilité pour chaque état de santé du pôle. Chaque probabilité est comprise en 0 et une probabilité maximale normalisée, par exemple 1, 10 ou 100. La somme des probabilités obtenues pour chaque état de santé est alors égale à la probabilité maximale normalisée. La probabilité la plus haute donne l'état de santé prédit pour le pôle. La probabilité de l'état de santé prédit pour le pôle fournit un niveau de confiance associé audit état de santé prédit.

Avantageusement, le procédé de diagnostic fait appel à deux algorithmes d'intelligence artificielle distincts, parmi lesquels un algorithme dit de classification et un algorithme dit de détection d'anomalie.

L'algorithme de classification est avantageusement un algorithme de classification supervisé, connu de l'Homme du métier. A titre d'exemple, l'algorithme de classification est un réseau de neurones, par exemple un réseau de neurones convolutif, un réseau de neurone récurrent ou un réseau transformeur. L'algorithme de classification prend en entrée au moins une prise de vue d'un contact électrique en position ouverte et fournit en sortie un état du pôle correspondant parmi un état critique, un état non conforme, un état conforme et un état bon, ainsi que le niveau de confiance associé entre 0 et la probabilité maximale normalisée. En variante, l'état du pôle est prédit uniquement parmi un état de santé bon et un état de santé non conforme.

L'algorithme de détection d'anomalie est avantageusement un algorithme d'apprentissage semi-supervisé, connu de l'Homme du métier. A titre d'exemple, l'algorithme de détection d'anomalie est une combinaison de réseaux de neurones. L'algorithme de détection d'anomalie prend en entrée au moins une prise de vue d'un contact électrique en position fermée et fournit en sortie un état du pôle parmi un état de répulsion et un état de non-répulsion.

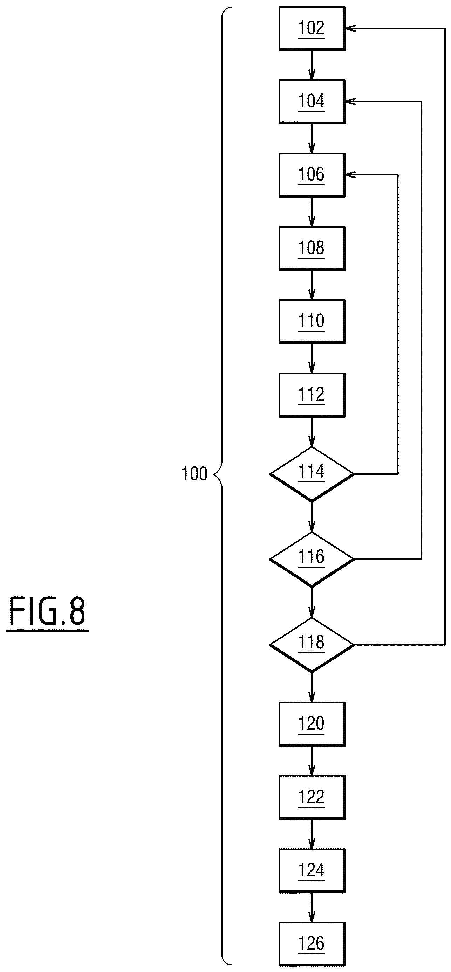

Chaque algorithme d'intelligence artificielle est entraîné, préalablement au procédé de diagnostic, au cours d'une phase d'initialisation 100 représentée sur la figure 8 et décrite dans la suite.

La phase d'initialisation 100 fait intervenir un ensemble de disjoncteurs d'entraînement. Les disjoncteurs d'entraînement sont avantageusement du même type que le disjoncteur 3 à diagnostiquer. Afin de pouvoir appliquer le procédé de diagnostic à différents types de disjoncteurs 3, les phases d'entraînement 100 sont avantageusement répétées sur différents disjoncteurs, fournissant un algorithme d'intelligence artificielle entraîné pour chaque type de disjoncteur.

Chaque phase d'initialisation 100 comprend *a minima* une prise de vue 108 d'un contact électrique de chaque pôle de chaque disjoncteur d'entraînement, une action de transformation aléatoire 122 de la prise de vue et un entraînement 126 de l'algorithme d'intelligence artificielle sur au moins un ensemble de prises de vue comprenant la prise de vue.

Dans l'exemple illustré sur la figure 8, la phase d'initialisation 100 commence par une ouverture ou une fermeture 102 du contact électrique du disjoncteur d'entraînement à photographier. Dans la phase d'initialisation 100 de l'algorithme de classification supervisé, cette étape 102 est une étape d'ouverture du contact électrique. Dans la phase d'initialisation 100 de l'algorithme de détection d'anomalie semi-supervisé, cette étape 102 est une étape de fermeture du contact électrique.

La phase d'initialisation 100 comprend ensuite une insertion 104 du guide 15 dans la chambre d'échappement 9 du pôle du disjoncteur d'entraînement comprenant le contact électrique à photographier, puis une phase d'insertion 106 de la fibre optique 23 dans le guide 15. La position de la fibre optique 23 par rapport au disjoncteur est ensuite fixée par insertion de la butée mâle 47 dans la butée femelle 59 puis par serrage des vis de microréglage 67. Comme expliqué précédemment, l'extrémité distale 25 de la fibre optique 23 est alors à proximité de la pastille de contact 5, au point P5.

Lors de l'étape de prise de vue 108, une prise de vue du contact électrique et de son environnement est réalisée par la sonde endoscopique 13 puis transmise au dispositif externe 11. La prise de vue comprend avantageusement le contact mobile comprenant la pastille de contact mobile 5, les joues positionnées de part et d'autre de la pastille de contact mobile 5 ainsi que le pare-étincelle.

La fibre optique 23 et le guide 15 sont ensuite retirés du disjoncteur d'entraînement lors d'une phase de retrait 110. La phase de retrait comprend avantageusement un retrait de la fibre optique 23 du guide 15, jusqu'à ce que le dispositif 1 soit en position dégagée, puis un retrait du guide 15 du disjoncteur 3.

Puis, la phase d'initialisation comprend une attribution 112 par un expert d'un état de santé réel du pôle, par une analyse de l'aspect de la pastille de contact 5 et de son environnement à partir de la prise de vue transmise au dispositif externe 11, ainsi que de conditions d'utilisation du disjoncteur 3. Dans la phase d'initialisation 100 de l'algorithme de classification supervisé, l'état de santé réel du pôle est choisi par l'expert parmi un état critique réel, un état non conforme réel, un état conforme réel et un état bon réel. En variante, l'état de santé réel du pôle est choisi uniquement parmi un état bon réel et un état non-conforme réel. Dans la phase d'initialisation 100 de l'algorithme de détection d'anomalie, l'état de santé réel du pôle est choisi par l'expert parmi un état de répulsion réel et un état de non répulsion réel.

En variante non représentée, l'étape d'attribution 112 a lieu avant l'étape de retrait 110.

Les étapes d'ouverture/fermeture 102, d'insertion 104 et 106, de prise de vue 108, de retrait 110 et d'attribution 112 sont répétées autant de fois que nécessaires pour constituer un ensemble de prises de vue d'entraînement de taille suffisante pour fiabiliser l'algorithme d'intelligence artificielle, par exemple 20 ou 50 fois.

Dans l'exemple illustré sur la figure 8, une première étape de test 114 consiste à vérifier si chaque côté d'un contact électrique a été photographié, et si non, à répéter à partir de l'insertion 106 de la fibre optique dans le guide 15 afin de photographier l'autre côté du contact électrique. Une deuxième étape de test 116 consiste à vérifier si chaque pôle du disjoncteur d'entraînement a été photographié, et si non, à répéter à partir de l'insertion 104 du guide 15 dans la chambre d'échappement 9 afin de photographier un autre pôle. Une troisième étape de test 118 consiste à vérifier si chaque disjoncteur d'entraînement de l'ensemble de disjoncteurs d'entraînement, correspondant au nombre de fois nécessaire, a été photographié, et si non, à répéter à partir de l'étape d'ouverture/fermeture 102 afin de photographier un autre disjoncteur d'entraînement. Ainsi, la phase d'initialisation illustrée sur la figure 8 permet de réaliser une prise de vue pour chaque côté de chaque contact électrique de chaque disjoncteur d'entraînement.

Les prises de vue ainsi obtenues sont ensuite réparties, au cours d'une étape de répartition 120, en un ensemble d'entrainement, un ensemble de test et un ensemble de validation.

Dans la phase d'initialisation 100 de l'algorithme de classification supervisé, les prises de vue sont réparties en un premier ensemble d'entraînement, un premier ensemble de validation et un premier ensemble de test. Chaque premier ensemble comprend au moins une prise de vue appartenant à chaque état parmi l'état critique réel, l'état non conforme réel, l'état conforme réel et l'état bon réel. Avantageusement, chaque état est représenté en proportion égale dans chacun des premiers ensembles. Cette répartition permet de mettre en œuvre un entraînement supervisé connu de l'Homme du métier.

Dans la phase d'initialisation 100 de l'algorithme de détection d'anomalie, les prises de vues sont réparties en un deuxième ensemble d'entraînement, un deuxième ensemble de validation et un deuxième ensemble de test. Le deuxième ensemble d'entraînement comprend uniquement des prises de vue dont le deuxième état de santé réel est l'état de répulsion réel et les deuxièmes ensembles de validation et de test comprenant au moins une prise de vue appartenant à chaque état parmi l'état de répulsion réel et l'état de non répulsion réel. Cette répartition permet de mettre en œuvre un entraînement semi-supervisé connu de l'Homme du métier.

Lors de l'étape de transformation aléatoire 122, au moins une transformation aléatoire est réalisée sur au moins une prise de vue. La transformation aléatoire comprend par exemple une modification aléatoire d'un contraste de la prise de vue, une modification aléatoire d'une luminosité de la prise de vue, une rotation aléatoire de la prise de vue et/ou un décalage horizontal ou vertical aléatoire de la prise de vue. Avantageusement, chaque prise de vue reçoit une probabilité aléatoire de transformation. Lorsque la probabilité de transformation est nulle, aucune transformation n'est réalisée. Lorsque la probabilité de transformation est non nulle, une combinaison d'une ou plusieurs transformation(s) est réalisée. Cette transformation aléatoire permet de reproduire une variabilité des prises de vue réalisées lors du procédé de diagnostic. En d'autres termes, la transformation aléatoire permet de rendre les algorithmes d'intelligence artificielle moins sensibles aux variations de conditions de la prise de vue.

La phase d'initialisation 100 comprend ensuite une adaptation 124 des prises de vue à l'algorithme d'intelligence artificielle concerné. L'étape d'adaptation 124 comprend par exemple une conversion de la prise de vue en niveaux de gris, une normalisation d'un contraste de la prise de vue et un redimensionnement de la prise de vue. L'étape d'adaptation 124 permet de rendre les prises de vue plus exploitables par l'algorithme d'intelligence artificielle.

Enfin, l'étape d'entraînement 126 comprend un entraînement, une validation et un test de l'algorithme d'intelligence artificielle sur l'ensemble d'entraînement, l'ensemble de validation et l'ensemble de test respectivement.

Au terme de la phase d'initialisation 100, l'algorithme d'intelligence artificielle concerné est entraîné et apte à prédire l'état de santé d'un pôle du disjoncteur 3 à partir d'une photo du contact du pôle.

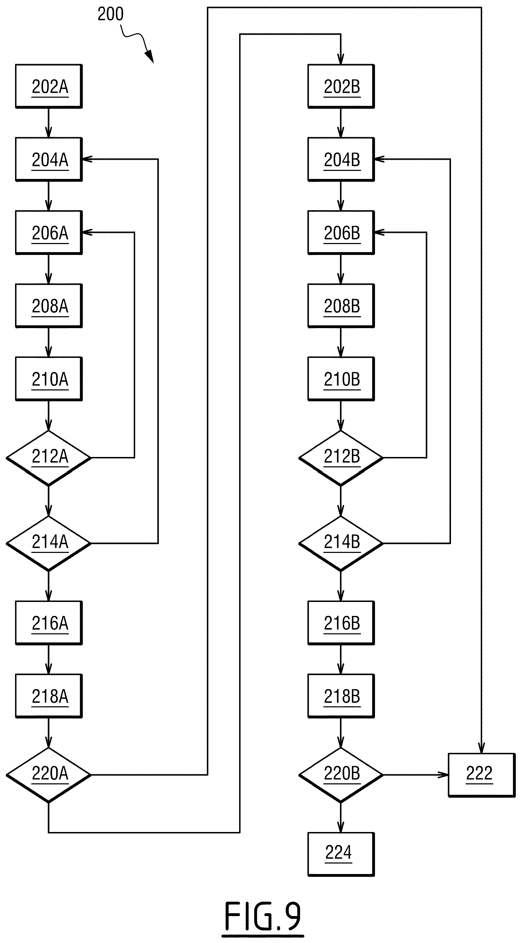

L'algorithme d'intelligence artificielle entraîné est intégré dans le dispositif externe 11, de sorte que le procédé de diagnostic 200, décrit dans la suite en référence à la figure 9, peut être mis en œuvre par le dispositif externe 11.

Le procédé de diagnostic 200 comprend au moins une prise de vue 206A ou 206B du contact électrique de chaque pôle du disjoncteur 3, au moins une détermination 218A ou 218B de l'état de santé de chaque pôle, une détermination 220A et 220B de l'état de santé du disjoncteur 3 et une restitution 222 et 224 de l'état de santé du disjoncteur 3.

Dans l'exemple illustré sur la figure 9, le procédé de diagnostic 200 comprend successivement une prédiction de l'état des pôles du disjoncteur 3 au moyen de l'algorithme de classification supervisé puis au moyen de l'algorithme de détection d'anomalie. L'état de santé du disjoncteur 3 est ensuite prédit en fonction des prédictions des deux algorithmes, comme décrit dans la suite.

Dans l'exemple représenté sur la figure 9, le procédé de diagnostic 200 comprend une étape 202A d'ouverture du contact du disjoncteur 3, une étape 204A d'insertion du guide 15 dans la chambre d'échappement 9, une étape 206A d'insertion de la fibre optique 23 dans le guide 15, une étape 208A de prise de vue du contact électrique et une étape 210A de retrait de la fibre optique 23 et du guide 15.

Le procédé comprend ensuite des étapes de test 212A et 214A similaires aux étapes de test 114 et 116 de la phase d'initialisation 100. Les étapes de test 212A et 214A permettent de répéter les étapes précédentes jusqu'à disposer d'une prise de vue de chaque côté de chaque contact électrique du disjoncteur 3.

Ensuite, le procédé de diagnostic 200 comprend une étape d'adaptation 216A, similaire à l'étape d'adaptation 124 de la phase d'initialisation 100, permettant d'adapter les prises de vue des pôles du disjoncteur 3 à l'algorithme de classification supervisé.

Puis, l'état de santé du pôle est prédit par l'algorithme de classification supervisé lors de l'étape de détermination 218A. Comme expliqué précédemment, l'état de santé du pôle prédit par l'algorithme de classification supervisé est un état critique, non conforme, conforme ou bon.

L'état de chaque pôle est ensuite pris en compte dans l'étape de détermination 220A de l'état de santé du disjoncteur. L'état de santé du disjoncteur est avantageusement prédit entre un état valide et un état non valide.

En particulier, si l'état de santé d'au moins un pôle prédit par l'algorithme de classification est l'état critique ou l'état non conforme, alors l'état prédit pour le disjoncteur 3 est l'état non valide. L'étape de restitution 222 de l'état non valide du disjoncteur est alors exécutée. La restitution prend par exemple la forme d'un affichage sur un écran du dispositif externe 11, permettant à un opérateur d'être informé que le disjoncteur 3 n'est pas valide et doit être remplacé pour continuer à assurer la sécurité de l'installation électrique.

A l'inverse, si l'algorithme de classification ne prédit l'état critique ou l'état non conforme pour aucun pôle, alors l'état de santé du pôle est prédit par l'algorithme de détection d'anomalie afin de déterminer la présence ou non d'une répulsion, pour conclure quant à l'état de santé du disjoncteur 3. Ainsi, les prises de vue du contact électrique en position fermée et les déterminations au moyen de l'algorithme de détection d'anomalie sont réalisées si et seulement si l'état de santé de chaque pôle prédit par l'algorithme de classification est l'état bon ou l'état conforme. Si tel est le cas, des étapes 202B à 220B sont exécutées.

Les étapes 202B à 220B sont similaires aux étapes 202A à 220A sauf pour les différences mentionnées ci-après.

Contrairement à l'étape 202A qui est une étape d'ouverture des contacts électriques, l'étape 202B est une étape de fermeture des contacts électriques du disjoncteur 3.

L'étape d'adaptation 216B adapte les prises de vue à l'algorithme de détection d'anomalie.

L'étape de détermination 218B de l'état de santé de chaque pôle est effectuée au moyen de l'algorithme de détection d'anomalie. L'état de santé prédit est alors l'état de répulsion ou l'état de non répulsion. Si l'état de santé d'au moins un pôle du disjoncteur 3 est l'état de répulsion, le disjoncteur est déclaré non valide et l'étape de restitution 222 de l'état de santé non valide du disjoncteur est exécutée. Si, à l'inverse, l'état de santé de tous les pôles est l'état de non répulsion, alors le disjoncteur est déclaré valide et l'étape de restitution 224 de l'état valide du disjoncteur est exécutée.

En résumé, l'état non valide du disjoncteur est déterminé si, pour au moins un pôle, l'état de santé du pôle prédit par l'algorithme de classification est l'état critique ou l'état non conforme, ou si l'état de santé du pôle prédit par l'algorithme de détection d'anomalie est l'état de répulsion ; l'état valide étant déterminé sinon.

Ainsi, au terme du procédé de diagnostic 200, l'état de santé du disjoncteur 3 installé dans l'installation électrique est connu et restitué par le dispositif externe 11. Cette connaissance permet de prendre des mesures adaptées de remplacement et/ou de maintenance du disjoncteur 3, afin d'assurer les fonctions de sécurité électriques essentielles de l'installation électrique.

Toute caractéristique décrite ci-dessus pour un exemple ou une variante, peut être mise en œuvre également dans les autres exemples ou variantes décrit ci-dessus, pour autant que techniquement possible.

## Revendications

1. Procédé de diagnostic (200) d'un disjoncteur (3) comprenant au moins un pôle, chaque pôle comprenant un contact électrique configuré pour basculer entre une position fermée et une position ouverte, **caractérisé en ce que** le procédé (200) comprend :
- pour chaque pôle du disjoncteur (3), au moins une prise de vue (208A, 208B) du contact électrique du pôle ;
- pour chaque pôle du disjoncteur (3), au moins une détermination (218A, 218B) d'un état de santé du pôle parmi au moins deux états au moyen d'un algorithme d'intelligence artificielle, l'algorithme d'intelligence artificielle prenant en entrée l'au moins une prise de vue du pôle et fournissant en sortie l'état de santé du pôle ;
- une détermination (220A, 220B) d'un état de santé du disjoncteur (3) parmi au moins deux états, en fonction de l'état de santé de chaque pôle ; et
- une restitution (222, 224) de l'état de santé du disjoncteur (3).

2. Procédé (200) selon la revendication 1, dans lequel, pour chaque pôle du disjoncteur (3) :
- la prise de vue (208A, 208B) du contact électrique est réalisée au moyen d'une sonde endoscopique (13) ; et
- le procédé (200) comprend, préalablement à la prise de vue (208A, 208B), une insertion (206A, 206B) de la sonde endoscopique (13) dans le disjoncteur (3) à proximité d'une pastille de contact mobile (5) appartenant au contact électrique.

3. Procédé (200) selon l'une quelconque des revendications précédentes, dans lequel, pour chaque pôle du disjoncteur (3) :
- la ou l'une des prise(s) de vue (208A) est réalisée alors que le contact électrique du pôle est en position ouverte ; et
- l'algorithme d'intelligence artificielle utilisé dans la ou l'une des détermination(s) (218A) de l'état de santé du pôle est un algorithme de classification prenant en entrée la ou l'une des prise(s) de vue réalisée(s) alors que le contact électrique est en position ouverte et fournissant en sortie un état du pôle parmi un état critique, un état non conforme, un état conforme et un état bon.

4. Procédé (200) selon l'une quelconque des revendications précédentes, dans lequel, pour chaque pôle du disjoncteur (3) :
- la ou l'une des prise(s) de vue (208B) est réalisée alors que le contact électrique du pôle est en position fermée ; et
- l'algorithme d'intelligence artificielle utilisé dans la ou l'une des détermination(s) (218B) de l'état de santé du pôle est un algorithme de détection d'anomalie prenant en entrée la ou l'une des prise(s) de vue réalisée(s) alors que le contact électrique est en position fermée et fournissant en sortie un état du pôle parmi un état de répulsion et un état de non-répulsion.

5. Procédé (200) selon les revendications 3 et 4, dans lequel la détermination (220A, 220B) de l'état de santé du disjoncteur (3) est effectuée entre un état valide et un état non valide, l'état non valide étant déterminé si, pour au moins un pôle :
- l'état de santé du pôle prédit par l'algorithme de classification est l'état critique ou l'état non conforme, ou
- l'état de santé du pôle prédit par l'algorithme de détection d'anomalie est l'état de répulsion ;
l'état valide étant déterminé sinon.

6. Procédé (200) selon la revendication 5, dans lequel la ou les prise(s) de vue (208B) des contacts électriques (5) en position fermée et la ou les détermination(s) (218B) au moyen de l'algorithme de détection d'anomalie sont réalisées si et seulement si l'état de santé de chaque pôle prédit par l'algorithme de classification est l'état bon ou l'état conforme.

7. Procédé (200) selon l'une quelconque des revendications précédentes, comprenant en outre, pour chaque prise de vue, au moins une action d'adaptation de la prise de vue (216A, 216B) parmi une conversion de la prise de vue en niveaux de gris, une normalisation d'un contraste de la prise de vue et un redimensionnement de la prise de vue.

8. Procédé (200) selon l'une quelconque des revendications précédentes, dans lequel chaque algorithme d'intelligence artificielle a été entraîné au cours d'une phase d'initialisation (100) préalable au procédé (200), chaque phase d'initialisation (100) comprenant :
- pour chaque disjoncteur d'entraînement parmi un ensemble de disjoncteurs d'entraînement et pour chaque pôle du disjoncteur d'entraînement, au moins une prise de vue (108) du contact du pôle ;
- pour au moins une prise de vue obtenue, au moins une action de transformation aléatoire de la prise de vue (122) ; et
- un entraînement de l'algorithme d'intelligence artificielle (126) sur au moins un ensemble de prises de vue d'entraînement parmi les prises de vue.

9. Procédé (200) selon les revendications 3 et 8, dans lequel la phase d'initialisation (100) de l'algorithme de classification comprend en outre :
- pour chaque prise de vue, une attribution (112) par un expert d'un premier état de santé réel du pôle parmi un état critique réel, un état non conforme réel, un état conforme réel et un état bon réel ; et
- une répartition (120) des prises de vues obtenues en un premier ensemble d'entraînement, un premier ensemble de validation et un premier ensemble de test, chaque premier ensemble comprenant au moins une prise de vue appartenant à chaque état parmi l'état critique réel, l'état non conforme réel, l'état conforme réel et l'état bon réel, l'entraînement (126) comprenant un entraînement, une validation et un test de l'algorithme de classification sur le premier ensemble d'entraînement, le premier ensemble de validation et le premier ensemble de test respectivement.

10. Procédé selon les revendications 4 et 8, dans lequel la phase d'initialisation (100) de l'algorithme de détection d'anomalie comprend en outre :
- pour chaque prise de vue, une attribution (112) par un expert d'un deuxième état de santé réel du pôle parmi un état de répulsion réel et un état de non répulsion réel ; et
- une répartition (120) des prises de vues obtenues en un deuxième ensemble d'entraînement, un deuxième ensemble de validation et un deuxième ensemble de test, le deuxième ensemble d'entraînement comprenant uniquement des prises de vue dont le deuxième état de santé réel est l'état de répulsion réel et les deuxièmes ensembles de validation et de test comprenant au moins une prise de vue appartenant à chaque état parmi l'état de répulsion réel et l'état de non répulsion réel, l'entraînement (126) comprenant un entraînement, une validation et un test de l'algorithme de détection d'anomalie sur le deuxième ensemble d'entraînement, le deuxième ensemble de validation et le deuxième ensemble de test respectivement.

11. Procédé (200) selon l'une quelconque des revendications 8 à 10, dans lequel l'action de transformation aléatoire (122) comprend au moins une action parmi une modification aléatoire d'un contraste de la prise de vue, une modification aléatoire d'une luminosité de la prise de vue, une rotation aléatoire de la prise de vue et un décalage horizontal ou vertical aléatoire de la prise de vue.

12. Programme d'ordinateur comportant des instructions logicielles qui, lorsqu'elles sont exécutées par un ordinateur, mettent en œuvre un procédé (200) selon l'une quelconque des revendications précédentes.
